(19) Europäisches Patentamt / European Patent Office / Office européen des brevets

(11) **EP 2 966 692 A1**

(12) **EUROPEAN PATENT APPLICATION**

(43) Date of publication:
**13.01.2016 Bulletin 2016/02**

(51) Int Cl.:
*H01L 31/0216* (2006.01)    *H01L 31/0687* (2012.01)
*H01L 31/18* (2006.01)

(21) Application number: **15176132.7**

(22) Date of filing: **09.07.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **11.07.2014 JP 2014143423**
**17.06.2015 JP 2015122271**

(71) Applicant: **Ricoh Company, Ltd.**
**Tokyo 143-8555 (JP)**

(72) Inventor: **SATO, Shunichi**
**Ohta-ku, Tokyo 143-8555 (JP)**

(74) Representative: **Leeming, John Gerard**
**J A Kemp**
**14 South Square**
**Gray's Inn**
**London WC1R 5JJ (GB)**

(54) **COMPOUND-SEMICONDUCTOR PHOTOVOLTAIC CELL AND MANUFACTURING METHOD OF COMPOUND-SEMICONDUCTOR PHOTOVOLTAIC CELL**

(57) A compound-semiconductor photovoltaic cell includes a first photoelectric conversion cell, which includes an absorption layer made of a first compound-semiconductor material which lattice matches with gallium arsenide (GaAs) or germanium (Ge); and a window layer made of aluminuin indium phosphide ($Al_{x1}In_{1-x1}P$ ($0<x1\leq1$)), arranged on an incident side of the absorption layer in a light incident direction, having a lattice constant less than a lattice constant of the absorption layer, and having a band gap greater than a band gap of the absorption layer.

FIG.9

EP 2 966 692 A1

Description

BACKGROUND OF THE INVENTION

1. Field of the Invention

The disclosures herein generally relate to a compound-semiconductor photovoltaic cell and a manufacturing method of the compound-semiconductor photovoltaic cell.

2. Description of the Related Art

Conventionally, there have been group III-V compound-semiconductor photovoltaic cells (See, for example, Fig. 12 in Japanese Patent Application No. 2007-115916). This photovoltaic cell is formed by a triple-junction cell including top, middle and bottom cells. On an n-AHnP window layer of the top cell, an n-GaAs contact layer having a comb shape is formed. Since a band gap of n-GaAs is small and light with a wavelength shorter than near-infrared light does not pass through the contact layer, the n-GaAs contact layer in a region where the light is caused to pass through is required to be removed, and thereby the n-GaAs contact layer is formed in a comb shape.

Moreover, conventionally, there have been photovoltaic cell apparatuses each including at least one cell unit configured so as to absorb a predetermined wavelength in a spectrum of the sun while being made of III-V group compound-semiconductor material; and an oxidized window layer provided on the cell unit in order to prevent a recombination of a light generation carrier on an upper surface of the photovoltaic cell apparatus (See, for example, Japanese Translation of PCT International Application Publication No. JP-T-2012-516578).

SUMMARY OF THE INVENTION

It is a general object of at least one embodiment of the present invention to provide a compound-semiconductor photovoltaic cell and a manufacturing method of the compound-semiconductor photovoltaic cell that substantially obviate one or more problems caused by the limitations and disadvantages of the related art.

In one embodiment, a compound-semiconductor photovoltaic cell includes a first photoelectric conversion cell, which includes an absorption layer configured with a first compound-semiconductor material which lattice matches with gallium arsenide (GaAs) or germanium (Ge); and a window layer configured with aluminum indium phosphide ($Al_{x1}In_{1-x1}P$ ($0<x1\leq1$)), arranged on an incident side of the absorption layer in a light incident direction, having a lattice constant less than a lattice constant of the absorption layer, and having a band gap greater than a band gap of the absorption layer.

In another embodiment, a manufacturing method of a compound-semiconductor photovoltaic cell, which includes a photoelectric conversion cell, includes forming an absorption layer configured with a compound-semiconductor material which lattice matches with gallium arsenide (GaAs) or germanium (Ge); and forming a window layer configured with aluminum indium phosphide ($Al_{x1}In_{1-x1}P$ ($0<x1\leq1$)) on a light incident side of the absorption layer in a light incident direction. The window layer has a lattice constant less than a lattice constant of the absorption layer and has a band gap greater than a band gap of the absorption layer.

In yet another embodiment, a manufacturing method of a compound-semiconductor photovoltaic cell includes forming a first photoelectric conversion cell by laminating a window layer configured with aluminum indium phosphide ($Al_{x1}In_{1-x1}P$ ($0<x1\leq1$)) on a first substrate formed of a compound-semiconductor, and laminating an absorption layer configured with a first compound-semiconductor material which lattice matches with gallium arsenide (GaAs) or germanium (Ge) on the window layer; laminating one or more second photoelectric conversion cells configured with a second compound-semiconductor material, which is GaAs-based, on the first photoelectric conversion cell; laminating a first junction layer on the second photoelectric conversion cells; laminating one or more third photoelectric conversion cells configured with a third compound-semiconductor material on a second substrate formed of a compound-semiconductor; laminating a second junction layer on the one or more third photoelectric conversion cells; joining a surface of the first junction layer opposite to a surface connected to the second photoelectric conversion cells and a surface of the second junction layer opposite to a surface connected to the third photoelectric conversion cells; and removing the first substrate. The window layer has a lattice constant less than a lattice constant of the absorption layer and has a band gap greater than a band gap of the absorption layer.

According to the embodiment of the present application, a compound-semiconductor photovoltaic cell and a manufacturing method of the compound-semiconductor photo voltaic cell are provided.

BRIEF DESCRIPTION OF THE DRAWINGS

Other objects and further features of embodiments will be apparent from the following detailed description when read in conjunction with the accompanying drawings, in which:

Fig. 1 is a cross-sectional diagram illustrating an example of a compound-semiconductor photovoltaic cell 100 according to a first embodiment;
Fig. 2 is a cross-sectional diagram illustrating an example of a compound-semiconductor photovoltaic cell 200 according to a second embodiment;
Fig. 3 is a cross-sectional diagram illustrating an example of a compound-semiconductor photovoltaic cell 300 according to a third embodiment;

Figs. 4A and 4B are diagrams illustrating an example of a manufacturing method of the compound-semiconductor photovoltaic cell 300 according to the third embodiment;

Figs. 5A and 5B are diagrams illustrating an example of the manufacturing method of the compound-semiconductor photovoltaic cell 300 according to the third embodiment;

Fig. 6 is a cross-sectional diagram illustrating an example of a compound-semiconductor photovoltaic cell 400 according to the fourth embodiment;

Fig. 7 is a diagram illustrating an example of a compound-semiconductor photovoltaic cell 400A according to a first variation of the fourth embodiment;

Fig. 8 is a diagram illustrating an example of a compound-semiconductor photovoltaic cell 400B according to a second variation of the fourth embodiment; and

Fig. 9 is a diagram illustrating an example of a compound-semiconductor photovoltaic cell 400C according to a third variation of the fourth embodiment.

## DESCRIPTION OF THE PREFERRED EMBODIMENTS

In the following, embodiment in which a compound-semiconductor photovoltaic cell and a manufacturing method of the compound-semiconductor photovoltaic cell according to the present invention are applied will be described.

Since band gap energy or a lattice constant of a compound-semiconductor varies depending on material composition, multi-junction type photovoltaic cells in which energy conversion efficiency is enhanced by sharing a wavelength range of solar light have been manufactured.

At present, there are triple-junction photovoltaic cells including a Ge cell/Ga(In)As cell/GaInP cell using a lattice matching material on a Ge substrate, which has almost the same lattice constant as gallium arsenide (GaAs), having band gaps for respective cells of 1.88 eV/1.40 eV/0.67 eV.

A compound-semiconductor photovoltaic cell has an efficiency which is about twice an efficiency of a silicon (Si)-based photovoltaic cell. However, by reason of cost of a substrate, small size of the substrate or the like, the compound-semiconductor photovoltaic cell is several orders of magnitude more expensive than the Si-based photovoltaic cell. Therefore, the compound-semiconductor photovoltaic cells have been used for a special purpose, such as an artificial satellite in space, for example.

Recently, a compound-semiconductor photovoltaic cell has been put to practical use for a terrestrial application (for general purpose on earth), by combining an inexpensive plastic lens and a small-sized photovoltaic cell, forming a concentration type cell, reducing an amount of compound-semiconductor which is more expensive than a normal planar cell, and realizing cost reduction.

A photovoltaic cell is preferable to receive light in an area as great as possible to generate carriers. This is because light does not enter a lower part of an electrode, and results in loss. However, the carriers are required to be collected, and a minimum electrode is provided on a surface of the photovoltaic cell. Moreover, the generated carriers are collected at the electrode, and it is necessary to design so that the carriers can move in a transverse direction in semiconductor material.

In a compound-semiconductor photovoltaic cell, a window layer having small electric resistance causes carriers to move, and collects carriers, which are generated according to light absorption inside the photovoltaic cell, at an upper electrode. Carrier concentration of the photovoltaic cell itself may be increased so as to reduce electric resistance of the photovoltaic cell itself. In this case, however, recombination of the carriers generated according to light absorption increases, to reduce the carriers, and contribution to electricity generation is reduced. This is not preferable.

Therefore, it is preferable to cause light generation carriers to move in the transverse direction mainly in a layer other than an absorption layer of the photovoltaic cell, to collect them at an electrode. At least, a window layer on the outermost surface is suitable.

In the following, first to fourth embodiments to solve the above-described problems will be explained.

<First embodiment>

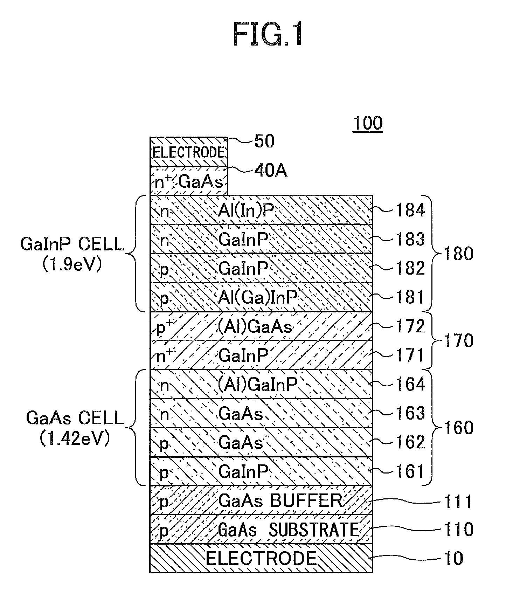

Fig. 1 is a cross-sectional diagram illustrating a compound-semiconductor photovoltaic cell 100 according to a first embodiment.

The compound-semiconductor photovoltaic cell 100 includes an electrode 10, a GaAs substrate 110, a GaAs buffer layer 111, a GaAs cell 160, a tunnel junction layer 170, a gallium indium phosphide (GaInP) cell 180, a contact layer 40A and an electrode 50.

The compound-semiconductor photovoltaic cell 100 according to the first embodiment is a double-junction type photovoltaic cell in which the GaAs cell 160 (1.42 eV) and the GaInP cell 180 (1.9 eV) are directly joined via the tunnel junction layer 170.

Here, the GaAs cell (1.42 eV) and the GaInP cell 180 (1.9 eV) are GaAs-based photoelectric conversion cells.

A GaAs-based photoelectric conversion cell is a photoelectric conversion cell which almost lattice matches with GaAs or Ge having a lattice constant close to GaAs, and is formed of a material system, a crystal of which can be grown on a GaAs substrate or on a Ge substrate. Here, a material, which almost lattice matches with GaAs or with Ge having almost the same lattice constant as GaAs, and a crystal of which can be grown on a GaAs substrate or on a Ge substrate, will be called a GaAs lattice matching system material. Furthermore, a cell configured with the GaAs lattice matching system material will be called a GaAs lattice matching system material cell.

The compound-semiconductor photovoltaic cell 100 is configured so that all layers almost lattice match with GaAs or with Ge having almost the same lattice constant as GaAs.

The compound-semiconductor photovoltaic cell 100 is manufactured by serially forming on the GaAs substrate 110, the GaAs buffer layer 111, the GaAs cell 160, the tunnel junction layer 170, the GaInP cell 180, the contact layer 40A and the electrode 50, and finally forming the electrode 10.

The GaAs substrate 110 is an example of a compound-semiconductor substrate. The GaInP cell 180 is an example of a first photoelectric conversion cell manufactured from a first compound semiconductor material which lattice matches with GaAs or Ge. The tunnel junction layer 170 is an example of a first tunnel junction layer. The GaAs cell 160 is an example of a second photoelectric conversion cell manufactured from a second compound-semiconductor material which is a GaAs-based material.

In Fig. 1, an incident direction of light is a direction from an upper part to a lower part in the drawing (direction from the GaInP cell 180 to the GaAs cell 160).

The electrode 10 is an electrode which is a lower electrode positioned on a deep side in the light incident direction. For the electrode 10, for example, an electrode in which metal layers of Ti (titanium)/Pt (platinum) /Au (gold) or the like may be used.

For the GaAs substrate 110, for example, a wafer of a single crystal of p-type (positive type) gallium arsenide may be used. For impurity, for example, carbon (C) or the like may be used.

The GaAs buffer layer 111 may be formed on the GaAs substrate 110 by MOCVD (metalorganic chemical vapor deposition) method, for example. For impurity, for example, zinc (Zn) or the like may be is used so that a conductivity type is p-type.

The GaAs cell 160 is formed on the GaAs buffer layer 111. The GaAs cell 160 includes a p-type GaInP layer 161, a p-type GaAs layer 162, an n-type (negative type) GaAs layer 163 and an n-type (Al)GaInP layer 164.

The GaInP layer 161, the GaAs layer 162, the GaAs layer 163 and the (Al)GaInP layer 164 are laminated on a surface of the GaAs buffer layer 111 in this order.

The GaInP layer 161 is a BSF (Back Surface field) layer arranged on a deep side in the light incident direction. A p-n junction in the GaAs cell 160 is structured by the GaAs layer 162 and the GaAs layer 163. The (Al)GaInP layer 164 is a window layer arranged on a near side in the light incident direction (light incident side).

Here, the expression "GaInF" of the GaInP layer 161 represents specifically $Ga_xIn_{1-x}P$ (0<x<1). However, in the following the simplified expression "GaInP" will be used. Moreover, the expression "(Al)GaInP" of the (Al)GaInP layer 164 represents specifically

$(Al_xGa_{1-x})_yIn_{1-y}P$ (0≤x<1, 0<y<1). However, in the following the simplified expression "(Al)GaInP" will be used. Furthermore, the notation "(Al)" covers the case of including Al and the case of not including Al.

Here, the GaAs cell 160 may be regarded as a cell, which is configured with the GaAs layer 162 and the GaAs layer 163 that structure the p-n junction, on the light incident side of which the (Al)GaInP layer 164 is formed, and on the deep side of which in the light incident direction the GaInP layer 161 is formed.

The GaInP layer 161 only has to have a band gap greater than or equal to a band gap (1.42 eV) of the p-type GaAs layer 162 and the n-type GaAs layer 163, since the GaInP layer 161 is used as the BSF layer. For impurity of the GaInP layer 161, for example, zinc (Zn) may be used.

In the GaAs layer 162, for example, by using Zn for the impurity, a conduction type becomes p-type.

In the GaAs layer 163, for example, by using Si for the impurity, a conduction type becomes n-type.

Band gaps of the GaAs layer 162 and the GaAs layer 163 are 1.42 eV.

Since the (Al)GaInP layer 164 is used as a window layer, the (Al)GaInP layer 164 has a band gap greater than the band gap (1.42 eV) of the p-type GaAs layer 162 and the n-type GaAs layer 163.

In the first embodiment, for the impurity of the (Al)GaInP layer 164, for example, silicon (Si) may be used.

The tunnel junction layer 170 is arranged between the GaAs cell 160 and the GaInP cell 180. Since the compound-semiconductor photovoltaic cell 100 shown in Fig. 1 is manufactured by laminating serially from the lower side, in a state shown in Fig. 1, the tunnel junction layer 170 is laminated on the GaAs cell 160.

The tunnel junction layer 170 includes an $n^+$-type GaInP layer 171, and a $p^+$-type (Al)GaAs layer 172. For an impurity in the GaInP layer 171, for example, tellurium (Te) may be used so that a conductivity type is n-type. For an impurity in the (Al)GaAs layer 172, for example, carbon (C) may be used so that a conductivity type is p-type. The $n^+$- type GaInP layer 171 and the $p^+$-type (Al)GaAs layer 172 form a thin p-n junction which is doped at high concentration.

Both the GaInP layer 171 and the (Al)GaAs layer 172 are doped at higher concentration than the GaInP cell 180. The tunnel junction layer 170 is a junction layer arranged so that an electric current flows between the p-type GaInP layer 182 in GaInP cell 180 and the n-type GaAs layer 163 in the GaAs cell 160 by the tunnel junction.

Here, the expression "GaInP" of the GaInP layer 171 represents specifically $Ga_xIn_{1-x}P$ (0<x<1). However, in the following the simplified expression "GaInP" will be used.

Moreover, the expression "(Al)GaAs" of the (Al)GaAs layer 172 represents specifically $Al_xGa_{1-x}As$ (0≤x<1). However, in the following the simplified expression "(Al)GaAs" will be used. Furthermore, the notation "(Al)" covers the case of including A1 and the case of not including Al.

The GaInP cell 180 is formed between the tunnel junction layer 170 and the contact layer 40A.

The GaInP cell 180 includes a p-type Al(Ga)InP layer 181, a p-type GaInP layer 182, an n-type GaInP layer 183 and an n-type Al(In)P layer 184.

The Al(Ga)InP layer 181, the GaInP layer 182, the GaInP layer 183 and the Al(In)P layer 184 are laminated on a surface of the tunnel junction layer 170 in this order. The GaInP cell 180 is laminated on the tunnel junction layer 170.

The GaInP cell 180 is configured with crystalline layers of GaInP which lattice matches with GaAs. In an actual manufacturing process, for example, the Al(Ga)InP layer 181, the GaInP layer 182, the GaInP layer 183 and the Al(In)P layer 184 are laminated in this order.

The Al(Ga)InP layer 181 is a BSF (Back Surface Field) layer arranged on a deep side in the light incident direction. A p-n junction in the GaInP cell 180 is structured by the GaInP layer 182 and the GaInP layer 183. The Al(In)P layer 184 is a window layer arranged on a near side in the light incident direction (light incident side).

Here, the GaInP cell 180 may be regarded as a cell, which is configured with the GaInP layer 182 and the GaInP layer 183 that structure the p-n junction, on the light incident side of which the Al(In)P layer 184 is formed, and on the deep side of which in the light incident direction the Al(Ga)InP layer 181 is formed.

The Al(Ga)InP layer 181 only has to have a band gap greater than or equal to a band gap (1.9 eV) of the p-type GaInP layer 182 and the n-type GaInP layer 183, since the Al(Ga)InP layer 181 is used as the BSF layer. For the impurity of the Al(Ga)InP layer 181, for example, zinc (Zn) may be used.

In the GaInP layer 182, for example, by using Zn for the impurity, a conduction type becomes p-type.

In the GaInP layer 183, for example, by using Si for the impurity, a conduction type becomes n-type.

The GaInP layer 182 and the GaInP layer 183 form an absorption layer of the GaInP cell 180. The GaInP layer 182 and the GaInP layer 183 may include aluminum (Al). Therefore, GaInP layer 182 and the GaInP layer 183 can be expressed by an (Al)GaInP layer. A notation (Al) represents both a composition including Al and a composition not including Al.

A band gap of the GaInP layer 182 and the GaInP layer 183 is 1.9 eV.

The Al(In)P layer 184 has a band gap greater than the band gap (1.9 eV) of the p-type GaInP layer 182 and the n-type GaInP layer 183, since the Al(In)P layer 184 is used as a window layer.

Here, the expression "Al(Ga)InP" of the Al(Ga)InP layer 181 represents specifically $(Al_xGa_{1-x})_yIn_{1-y}P$ ($0<x\leq1$, $0<y<1$). However, in the following the simplified expression "Al(Ga)InP" will be used. The notation "(Ga)" represents both a composition including Ga and a composition not including Ga. The expression "Al(In)P" of the Al(In)P layer 184 represents specifically $Al_xIn_{1-x}P$ ($0<x\leq1$). However, in the following the simplified expression "'Al(In)P" will be used. The notation "(In)" represents both a composition including In and a composition not including In.

Moreover, the expression "GaInP" of the GaInP layer 182 represents specifically $Ga_xIn_{1-x}P$ ($0<x<1$). However, in the following the simplified expression "GaInP" will be used. The above-described expression is also used for the GaInP layer 183. A value x of the GaInP layer 182 may be different from that of the GaInP layer 183.

In the first embodiment, the Al(In)P layer 184 has a band gap greater than a band gap (1.9 eV) of the p-type GaInP layer 182 and the n-type GaInP layer 183. For the impurity of the Al(In)P layer 184, for example, silicon (Si) may be used.

Moreover, the Al(In)P layer 184 has a lattice constant less than a lattice constant of the p-type GaInP layer 182 and the n-type GaInP layer 183, which are absorption layers. The Al(In)P layer 184 can be, more specifically, expressed as $Al_xIn_{1-x}P$, where x is preferably greater than 0.5 (x>0.5).

Since the Al(Zn)P layer 184 has the lattice constant less than the lattice constant of the absorption layer, the Al(In)P layer 184 includes a tensile strain. Since the compound-semiconductor photovoltaic cell 100 is basically configured so that all layers lattice match with GaAs, or Ge having lattice constant which is close to GaAs, the Al(In)P layer 184, which has a lattice constant less than GaAs and Ge, has a tensile strain.

The Al(In)P layer having a tensile strain is formed by laminating the $Al_xIn_{1-x}P$ layers, a composition of which is adjusted so as to have a lattice constant less than the lattice constant of GaAs. or Ge, on a layer lattice matching with GaAs or Ge, to have a tensile strain.

Here, the layers, a composition of which is adjusted so as to lattice match with GaAs or Ge, are for example, the GaInP cell 180 and the GaAs cell 160.

The $Al_xIn_{1-x}P$ having a lattice constant which is smaller than GaAs has a greater band gap compared with AlInP, which lattice matches with GaAs, or Ge.

The contact layer 40A is laminated on the GaInP cell 180 in order to perform an ohmic connection to the electrode 50. For example, a gallium arsenide (GaAs) layer is used for the contact layer 40A. Meanwhile, a Ga(In)As layer having a thickness in a range where a lattice relaxation does not occur, and indium (In) is added, may be used as a contact layer 40A.

The electrode 50 is, for example, a metallic thin film, such as Ti/Pb/Au, and formed on the contact layer 40A.

Meanwhile, the contact layer 40A is formed by removing a gallium arsenide (GaAs) layer, which was formed on a whole surface of the Al(In)P layer 184, using the electrode 50 as a mask. The gallium arsenide (GaAs) layer of a part of the GaAs layer formed on the whole surface of the Al(In)P layer 184, other than the contact layer 40A positioned below the electrode 50, is removed so as not to absorb solar light by the GaAs layer before absorbing solar light by the GaInP cell 180,

Moreover, the compound-semiconductor photovoltaic cell 100 has a configuration so that solar light enters the compound-semiconductor photovoltaic cell 100 from a side of a cell of a wide band gap (side of the GaInP cell 180). Meanwhile, an antireflection film is preferably provided on a surface of the Al(In)P layer 184, which solar light enters.

Here, band gaps of a direct transition ($\Gamma$ band) and an indirect transition (X band) of the Al(In)P ($Al_x In_{1-x} P$) layer 184 will be explained.

The band gaps of the direct transition ($\Gamma$ band) and the indirect transition (X band) of the $Al_x In_{1-x} P$ are obtained by the following formulas:

$$E_g(\Gamma) = 1.34 + 2.23\ x \qquad (1)$$

$$E_g(x) = 2.24 + 0.18\ x \qquad (2)$$

The Al composition x of the Al(In)P ($Al_x In_{1-x} P$) layer 184 lattice matching with GaAs substrate 110 is 0.52, and $E_g(\Gamma)$=2.50 eV and Eg(x)=2.33 eV are obtained.

Since an energy of the band gap of the X band (Eg(x)) is lower than an energy of the band gap of the $\Gamma$ band, the Al(In)P ($Al_x in_{1-x} P$) layer 184 is an indirect transition semiconductor.

Generally, an indirect transition semiconductor has an absorption coefficient which is smaller than a direct transition semiconductor by about two orders of magnitude. In other words, the indirect transition semiconductor is preferable as a window layer since absorption is small.

However, the above-described energies of 2.50 eV and 2.33 eV are converted into wavelengths of 496 nm and 531 nm, respectively, which are very close to each other, and light having wavelength shorter than 496 nm is absorbed to the same extent as the direct transition semiconductor.

Furthermore, since solar light having wavelength around 500 nm has the greatest intensity in a solar light spectrum, the absorption to the same extent as the direct transition semiconductor is influential.

For this reason, in the compound-semiconductor photovoltaic cell 100 according to the first embodiment, a lattice constant of the Al(In)P ($Al_x In_{1-x} P$) layer 184 which is a window layer is made less than the lattice constant of the absorption layer lattice matching with GaAs or Ge (the p-type GaInP layer 182 and the n-type GaInP layer 183).

In order to make the lattice constant less than the lattice constant of the absorption layer which lattice matches, the Al composition of the Al(In)P ($Al_x In_{1-x} P$) layer 184 is increased, thereby the band gap is made greater.

Here, for example, as a case of increasing the Al composition extremely, the case of x=1 will be explained, The composition formula in this case becomes AlP. In this case, the energies of band gaps are obtained as $E_g(\Gamma)$=3.57 eV (347 nm) and $E_g(x)$=2.42 eV (512 nm). It is found that the increase in the energy of the $\Gamma$ band is greater than the X band, and that the difference between the $\Gamma$ band and the X band increases. That is, even for the light of the short wavelength side, such as around 500 nm, absorption decreases.

In this way, since in the case of increasing the Al composition, the absorption of the light on the short wavelength side decreases, the Al composition of the Al(In)P ($Al_x In_{1-x} P$) layer 184 is increased.

In the first embodiment, the n-type Al(In)P ($Al_x In_{1-x} P$) layer 184 has a lattice constant less than the lattice constant of the GaAs substrate 110. The lattice constant of the $Al_x In_{1-x} P$ which is an indirect transition semiconductor decreases as the Al composition x is increased. Moreover, though both band gaps of the $\Gamma$ band and the X band increase, change in the $\Gamma$ band, which has a greater absorption coefficient, is greater, and the absorption of the light of shorter wavelength decreases.

As described above, according to the first embodiment, absorption of light at the Al(In)P ($Al_x In_{1-x} P$) layer 184, which is a window layer, can be reduced, light of high energy can be transmitted, and thereby a highly-efficient compound-semiconductor photovoltaic cell 100 can be provided.

<Second embodiment>

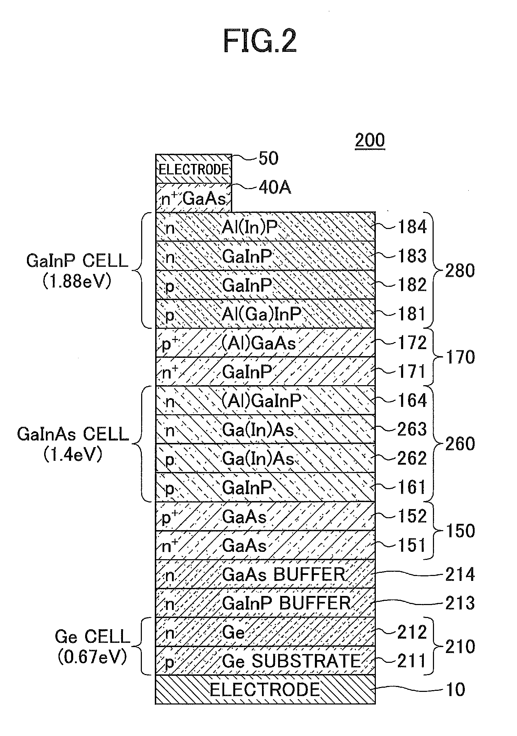

Fig. 2 is a cross-sectional diagram illustrating a compound-semiconductor photovoltaic cell 200 according to a second embodiment.

The compound-semiconductor photovoltaic cell 200 is obtained by replacing, in the compound-semiconductor photovoltaic cell 100 according to the first embodiment, the GaAs cell 160 (1.42 eV) and the GaInP cell 180 (1.9 eV) by a GaInAs cell 260 (1.4 eV) and a GaInP cell 280 (1.88 eV), respectively.

Moreover, the compound-semiconductor photovoltaic cell 200 becomes a triple-junction type by further adding a Ge cell 210 (0.67 eV).

The compound-semiconductor photovoltaic cell 200 includes an electrode 10, a Ge cell 210, a GaInP buffer layer 213, a GaAs buffer layer 214, a tunnel junction layer 150, a GaInAs cell 260, a tunnel junction layer 170, a GaInP cell 280, a contact layer 40A and an electrode 50.

Meanwhile, in the compound-semiconductor photovoltaic cell 200, to the same composition element as in the compound-semiconductor photovoltaic cell 100 according to the first embodiment, the same reference numeral is assigned, and an explanation thereof will be omitted.

The compound-semiconductor photovoltaic cell 200 is manufactured by serially forming on a Ge substrate 211 of the Ge cell 210, a Ge layer 212, the GaInP buffer layer 213, the GaAs buffer layer 214, the tunnel junction layer 150, the GaInAs cell 260, the tunnel junction layer 170, the GaInP cell 280, the contact layer 40A and the electrode 50, and finally by forming an electrode 10.

The Ge cell 210 includes the p-type Ge substrate 211 and the n-type Ge layer 212. A conduction type of the Ge layer 212 may be made to be n-type by using diffusion of phosphorus (P) inside the GaInP buffer layer 213 caused to grow on the Ge layer 212. The Ge cell 210 is an example of one of plural second photoelectric conversion cells.

The GaInP buffer layer 213 may be formed on the Ge cell 210 by MOCVD method, for example. For impurity, for example, silicon (Si) or the like may be used so that a conductivity type is n-type. The GaInP buffer layer 213 is an example of a first buffer layer.

The GaAs buffer layer 214 may be formed on the GaInP buffer layer 213 by MOCVD method, for example. For impurity, for example, silicon (Si) or the like may be used so that a conductivity is n-type. The GaAs buffer layer 214 is an example of a second buffer layer.

The tunnel junction layer 150 is arranged between the GaAs buffer layer 214 and the GaInAs cell 260.

The tunnel junction layer 150 includes an $n^+$-type GaAs layer 151 and a $p^+$-type GaAs layer 152. For impurity, for example, tellurium (Te) may be used so that a conductivity type is n-type. For impurity, for example, carbon (C) may be used so that a conductivity type is p-type. The $n^+$-type GaAs layer 151 and the $p^+$-type GaAs layer 152 configure a thin p-n junction which is doped at high concentration.

Both the GaAs layers 151 and 152 of the tunnel junction layer 150 are doped at higher concentration than the GaInAs cell 260. The tunnel junction layer 150 is a junction layer arranged so that an electric current flows between the p-type Ga(In)As layer 262 of the GaInAs cell 260 and the n-type Ge layer 212 of the Ge cell 210 by the tunnel junction. The GeAs has a smaller band gap than the GaInP and AlGaAs, and a resistance value can be reduced even in a tunnel junction of a homo junction.

The GaInAs cell 260 includes a p-type GaInP layer 161, a p-type Ga(In)As layer 262, an n-type Ga(In)As layer 263 and an n-type (Al)GaInP layer 164. The GaInAs cell 260 is a GaAs-based photoelectric conversion cell.

That is, the GaInAs cell 260 is obtained by replacing, in the GaAs cell 160 according to the first embodiment (See Fig. 1), the p layer and n layer which perform photoelectric conversion by the Ga(In)As layer 262 and the Ga(In)As layer 263, which have an In composition of 1% and a band gap of 1.40 eV.

Here, the expression "Ga(In)As" of the Ga(In)As layer 262 represents specifically $Ga_{1-x}In_xAs$ ($0 \leq x < 1$). However, in the following the simplified expression "Ga(In)As" will be used. Moreover, the notation "(In)" covers the case of including In and the case of not including In. The above-described expression is also used for the Ga(In)As layer 263. However, a value of x of the Ga(In)As layer 262 may be different from that of the Ga(In)As layer 263.

The GaInP cell 280 includes, as in the GaInP cell 180 (1.9 eV) according to the first embodiment, a p-type Al(Ga)InP layer 181, a p-type GaInP layer 182, an n-type GaInP layer 183 and an n-type Al(In)P layer 184. In the GaInP cell 280, a band gap is adjusted to 1.88 eV by adjusting a film forming condition or the like. That is, band gaps of the p-type GaInP layer 182 and the n-type GaInP layer 183 are adjusted to 1.88 eV. The GaInP cell 280 is an example of a first photoelectric conversion cell.

The compound-semiconductor photovoltaic cell 200 is configured so that the respective layers almost lattice match with germanium (Ge) in order to serially form the respective layers on the Ge substrate 211.

Therefore, the Al(In)P layer 184, in the second embodiment, is formed by laminating Al(In)P, a composition of which is adjusted so as to have a smaller lattice constant than the lattice constant of Ge, on a layer lattice matching with Ge, to have a tensile strain.

Here, the layers lattice matching with Ge are all of the Ge layer 212, the GaInP buffer layer 213, the GaAs buffer layer 214, the tunnel junction layer 150, the GaInAs cell 260, the tunnel junction layer 170, the Al(Ga)InP layer 181, the GaInP layer 182 and the GaInP layer 183.

Meanwhile, since the lattice constant of germanium (Ge) is approximately the same as the lattice constant of GaAs, the Al(In)P layer 184 according to the first embodiment can be used in the second embodiment approximately as it is. But, the lattice constant of the Al(In)P layer 184 may be adjusted appropriately in Ge.

The n-type Al(In)P ($Al_xIn_{1-x}P$) layer 184 has a lattice constant smaller than the lattice constant of the Ge substrate 211. The lattice constant of $Al_xIn_{1-x}P$, which is an indirect transition semiconductor, becomes smaller as the Al composition x is increased. Moreover, both band gaps of the $\Gamma$ band and the X band increase. But, a change of the $\Gamma$ band, an absorption coefficient of which is greater, is greater, and an absorption of light with shorter wavelength decreases.

As described above, according to the second embodiment, absorption of light at the Al(In)P ($Al_xIn_{1-x}P$) layer 184, which is a window layer, can be reduced, light of high energy can be transmitted, and thereby a highly-efficient compound-semiconductor photovoltaic cell 200 can be provided.

Meanwhile, in the present embodiment, as described above, the example including a Ge cell 210 in which the Ge layer 212 is formed on the Ge substrate 211 is explained. However, instead of the Ge cell 210, a cell formed from a material, which lattice matches with GaAs and has a smaller band gap than the GaInAs cell 260, such as GaInNAs, may be used. In this case, the cell used instead of the Ge cell 210 only has to have a band gap smaller than the GaInAs cell 260.

<Third embodiment>

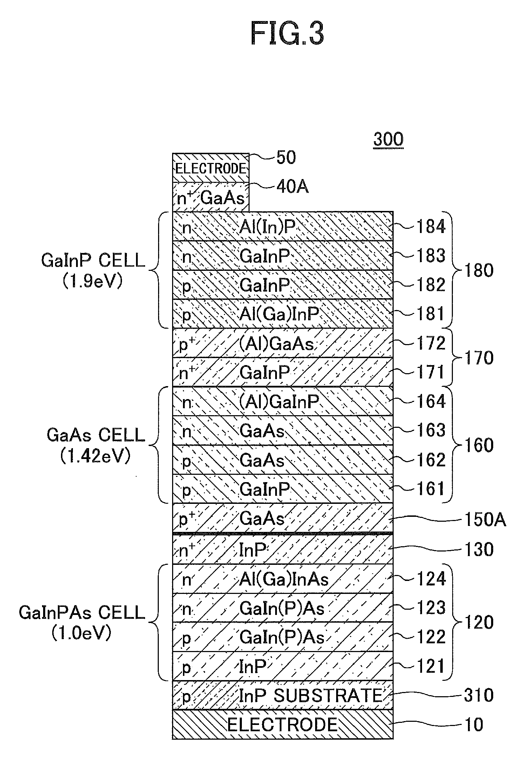

Fig. 3 is a cross-sectional diagram illustrating an example of a compound-semiconductor photovoltaic cell 300 according to a third embodiment.

The compound-semiconductor photovoltaic cell 300 according to the third embodiment includes an electrode 10, an InP substrate 310, a GaInPAs cell 120, a junction layer 130, a tunnel junction layer 150A, a GaAs cell 160, a tunnel junction layer 170, a GaInP cell 180, a contact layer 40A and an electrode 50.

The compound-semiconductor photovoltaic cell 300 is obtained by removing the GaAs substrate 110 and the GaAs buffer -layer 111 from the compound semiconductor photovoltaic cell 100 according to the first embodiment, and adding the InP substrate 310, the GaInPAs cell 120, the junction layer 130 and the tunnel junction layer 150A to it.

The compound-semiconductor photovoltaic cell 300 is manufactured by joining a laminated body, which includes the electrode 10, the InP substrate 310, the GaInPAs cell 120 and the junction layer 130, and a laminated body including the tunnel junction layer 150A, the GaAs cell 160, the tunnel junction layer 170, the GaInP cell 180, the contact layer 40A and the electrode 50.

In this case, by joining the junction layer 130 and the tunnel junction layer 150A, the two laminated bodies are joined, and a tunnel junction is formed by the junction layer 130 and the tunnel junction layer 150A.

For the InP substrate 310, for example, a wafer of a single crystal of p-type indium phosphide may be used. For impurity, for example, zinc (Zn) or the like may be used.

Meanwhile, the GaInPAs cell 120 is an example of a third photoelectric conversion cell. The GaAs cell 160 and the GaInP cell 180 are examples of a second photoelectric conversion cell and a first photoelectric conversion cell, respectively.

The GaInPAs cell 120 is formed on a surface of the InP substrate 310. The GaInPAs cell 120 includes a p-type InP layer 121, a p-type GaIn(P)As layer 122, an n-type GaIn(P)As layer 123 and an n-type Al(Ga)InAs layer 124.

The GaInPAs cell 120 is configured with crystalline layers of GaInPAs which lattice matches with InP.

The InP layer 121, the GaIn(P)As layer 122, the GaIn(P)As layer 123 and the Al(Ga)InAs layer 124 are laminated on the surface of the InP substrate 310 in this order.

The InP layer 121 is a BSF (Back Surface Field) layer arranged on a deep side in the light incident direction. A p-n junction in the GaInAs cell 120 is structured by the GaIn(P)As layer 122 and the GaIn(P)As layer 123.

The Al(Ga)InAs layer 124 is a window layer arranged on a near side in the light incident direction (light incident side).

Here, the GaInPAs cell 120 may be regarded as a cell, which is configured with the GaIn(P)As layer 122 and the GaIn(P)As layer 123 that structure the p-n junction, on the light incident side of which the Al(Ga)InAs layer 124 is formed, and on the deep side of which in the light incident direction the InP layer 121 is formed.

The InP layer 121 has a band gap greater than a band gap (1.0 eV) of the p-type GaIn(P)As layer 122 and the n-type GaIn(P)As layer 123, since the InP layer 121 is used as the BSF layer. For impurity of the InP layer 121, for example, zinc (Zn) may be used.

In the GaIn(P)As layer 122, for example, by using Zn for the impurity, a conduction type becomes p-type.

In the GaIn(P)As layer 123, for example, by using Si for the impurity, a condition type becomes n-type.

In the GaIn(P)As layer 122 and the GaIn(P)As layer 123, the ratio of Ga, x, and the ratio of P, y, are adjusted so that the band gaps are 1.0 eV.

The Al(Ga)InAs layer 124 has a band gap greater than the band gaps (1.0 eV) of the GaIn(F)As layer 122 and the GaIn(P)As layer 123, since the Al(Ga)InAs layer 124 is used as a window layer.

Here, the expression "GaIn(P)As" of the GaIn(P)As layer 122 represents specifically $Ga_xIn_{1-x}P_yAs_{1-y}$ (0<x<1, 0≤y<1). However, in the following the simplified expression "GaIn(P)As" will be used. The notation "(P)" represents both a composition including P and a composition not including P. The above-described expression is also used for the GaIn(P)As layer 123. However, values of x and y of the GaIn(P)As layer 122 may be different from those of the GaIn(P)As layer 123.

The expression "Al(Ga)InAs" of the Al(Ga)InAs layer 124 represents specifically $(Al_xGa_{1-x})_yIn_{1-y}As$ (0<x≤1, 0<y<1). However, in the following the simplified expression "Al(Ga)InAs" will be used. Furthermore, the notation "(Ga)" covers the case of including Ga and the case of not including Ga.

In the third embodiment, the band gap of the Al(Ga)InAs layer 124 is set to 1.5 eV, for example. For the impurity of the Al(Ga)InAs layer 124, for example, silicon (Si) may be used.

Since AlGaInAs lattice matches with InP, it is suitable for being laminated on the GaIn(P)As layer 123.

The junction layer 130 is joined to the tunnel junction layer 150A in the process of manufacturing the compound-semiconductor photovoltaic cell 300 by a cleaning treatment and a surface activation treatment. The compound-semiconductor photovoltaic cell 300 is manufactured by joining the two laminated bodies.

The junction layer 130 is formed on an uppermost surface of one of the two laminated bodies, and the tunnel junction layer 150A is formed on an uppermost surface of the other laminated body. By joining the junction layer 130 and the tunnel junction layer 150A, the compound-semiconductor photovoltaic cell 300, as shown in Fig. 3, is manufactured.

As the junction layer 130, an n$^+$-type InP layer is used. An impurity concentration of the junction layer 130 is set to be higher than an impurity concentration of the Al(Ga)InAs layer 124. Therefore, a conduction type of the junction layer 130 is n$^+$-type.

The InP layer used as the junction layer 130 has, for example, a band gap of 1.35 eV.

The tunnel junction layer 150A is a p$^+$-type GaAs layer. For an impurity, by which a conduction type becomes p-type, for example, carbon (C) may be used. The tunnel junction layer 150A configures the junction layer 130 and a thin p-n junction which is doped at high concentration.

The tunnel junction layer 150A and the junction layer 130 are doped at higher concentration than the GaAs cell 160.

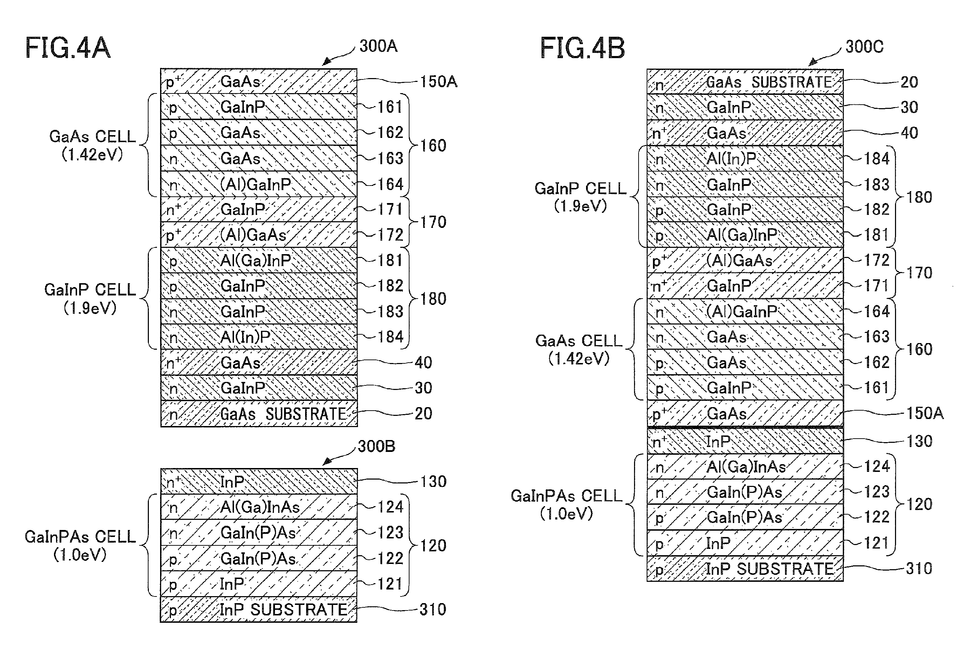

Next, a manufacturing method of the compound-semiconductor photovoltaic cell 300 according to the third embodiment will be explained with reference to Figs. 4A to 5B.

Figs. 4A to 5B are diagrams illustrating the manufacturing method of the compound-semiconductor photovoltaic cell 300 according to the third embodiment.

At first, as shown in Fig. 4A, a laminated body 300B is manufactured using an InP substrate 310, while manufacturing a laminated body 300A using a GaAs substrate 20. The GaAs substrate 20 is an example of a first compound-semiconductor substrate. The InP substrate 310 is an example of a second compound-semiconductor substrate.

Here, a GaInP cell 180 included in the laminated body 300A is configured with crystalline layers of GaInP which lattice matches with GaAs, and is formed on the GaAs substrate 20. Moreover, a GaInPAs cell 120 included in the laminated body 300B is configured with crystalline layers of GaInPAs which lattice matches with InP, and is formed on the InP substrate 310.

In this way, lattice constants of the laminated body 300A and the laminated body 300B are different from each other. The compound-semiconductor photovoltaic cell 300 according to the third embodiment is manufactured by directly joining the laminated body 300A and the laminated body 300B, lattice constants of which are different from each other.

Since the lattice constant of InP is about 5.87 Å (angstroms), it is only necessary to adjust a composition so that the GaInPAs cell 120 formed on the InP substrate 310 has a lattice constant quite close to the lattice constant (about 5.87 Å) of InP.

Moreover, since the lattice constant of GaAs is about 5.65 Å, it is only necessary to adjust compositions so that a GaAs cell 160 and a GaInP cell 180, which are formed on the GaAs substrate 20, have lattice constants quite close to the lattice constant (about 5.65 A) of GaAs.

The laminated body 300A is manufactured as follows. First, on the GaAs substrate 20, a GaInP etching stop layer 30, an n$^+$-type GaAs contact layer 40 are laminated, by MOCVD (Metal Organic Chemical Vapor Deposition) method. Next, on the GaAs substrate 20, on which the etching stop layer 30 and the contact layer 40 are laminated, the GaInP cell 180 is laminated (formed). Then, the tunnel junction layer 170 is laminated (formed) on the GaInP cell 180. Furthermore, the GaAs cell 160 is laminated (formed) on the tunnel junction layer 170. Then, the tunnel junction layer 150A is laminated (formed) on the GaAs cell 160, and thereby the laminated body 300A is completed. Meanwhile, the expression "GaInP" of the GaInP etching stop layer 30 represents specifically Ga$_x$In$_{1-x}$P (0<x<1).

Here, the GaInP cell 180 includes an Al(In)P layer 184 which lattice matches with GaAs, a GaInP layer 183, a GaInP layer 182 and an Al(Ga)InP layer 181. The Al(Ga)InP layer 181 is a BSF layer, and the Al(In)P layer 184 is a window layer.

Moreover, the tunnel junction layer 170 includes an (Al)GaAs layer 172 and an GaInP layer 171.

The GaAs cell 160 includes an (Al)GaInP layer 164, a GaAs layer 163, a GaAs layer 162 and a GaInP layer 161. The GaInP layer 161 is a BSF layer, and the (Al)GaInP layer 164 is a window layer.

Moreover, the tunnel junction layer 150A is configured by a p$^+$-type GaAs layer.

Upon the lamination (growth) of the laminated body 300A, the lower side having the GaAs substrate 20 is a light incident side. Since the laminated body 300A is turned upside down upon joining to the laminated body 300B later, the laminated body 300A grows from an opposite direction with respect to the vertical relationship shown in Fig. 1.

Specifically, it serially grows from a cell of a wide band gap (GaInP cell 180) to a narrow gap cell (GaAs cell 160). Moreover, finally a p-side becomes the lower side (deep side in the light incident direction).

Moreover, the laminated body 300B is manufactured as follows. First, on the InP substrate 310, by MOCVD method, the GaInPAs cell 120 is laminated. Then, the junction layer 130 is laminated (grown) on the GaInPAs cell 120. In the laminated body 300B shown in Fig. 4A, a side of the junction layer 130, which is opposite to the InP substrate 310, is a light incident side.

The GaInPAs cell 120 includes, from a side of the InP substrate 310, an InP layer 121, a GaIn(P)As layer 122, a GaIn(P)As layer 123 and an Al(Ga)InAs layer 124. The InP layer 121 is a BSF layer, and the Al(Ga)InAs layer 124 is a window layer.

As described above, the laminated bodies 300A and 300B are manufactured through epitaxial growth by MOCVD method.

Next, as shown in Fig. 4B, the laminated bodies 300A and 300B which are manufactured through epitaxial growth are joined directly.

Surfaces of the tunnel junction layer 150A of the laminated body 300A and the junction layer 130 of the laminated body 300B are subjected to a cleaning treatment and a surface activation treatment, and the junction layer 130 and the tunnel junction layer 150A are joined directly. The surface activation treatment is performed by a nitrogen ($N_2$) plasma treatment, and the junction is performed in a vacuum at temperature of 150 °C.

According to the above-described processes, a laminated body 300C, as shown in Fig. 4B, is prepared. The laminated body 300C is manufactured by placing the laminated body 300A, which is turned upside down, i.e. in a state where the tunnel junction layer 150A is on the bottom side, on the junction layer 130 of the laminated body 300B, shown in Fig. 4A, and joining the junction layer 130 and the tunnel junction layer 150A.

Meanwhile, the tunnel junction layer 150A is an example of a first junction layer, and the junction layer 130 is an example of a second junction layer.

The laminated body 300C is configured by laminating on the InP substrate 310, the GaInPAs cell 120, the junction layer 130, the tunnel junction layer 150A, the GaAs cell 160, the tunnel junction layer 170, the GaInP cell 180, the GaAs contact layer 40, an InP etching stop layer 30 and the GaAs substrate 20, in this order.

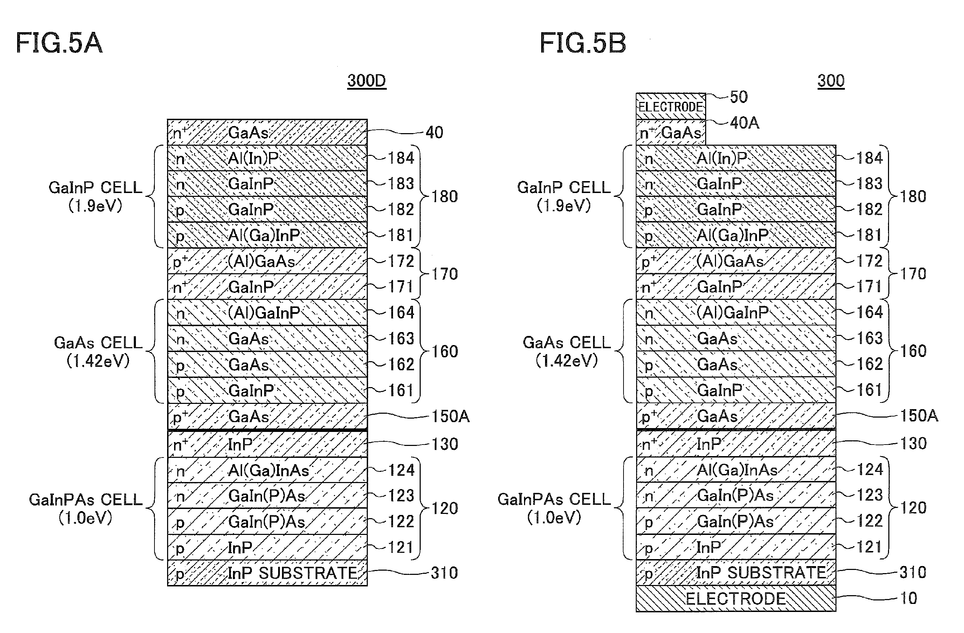

Next, the GaAs substrate 20 and the GaInP etching stop layer 30 are removed from the laminated body 300C, shown in Fig. 4B by selective etching, respectively, and thereby a laminated body 300D, shown in Fig. 5A, is obtained.

The GaAs substrate 20 and the GaInP etching stop layer 30 may be etched as follows:

The GaAs substrate 20 can be etched, for example, with a mixture of sulfuric acid ($H_2SO_4$), hydrogen peroxide ($H_2O_2$) and water ($H_2O$) as wet etching solution. Since GaInP in the GaInP etching stop layer 30 does not dissolve in the mixture of sulfuric solution, hydrogen peroxide and water, the wet etching process can be stopped at the GaInP etching stop layer 30.

Moreover, the GaInP etching stop layer 30 can be etched, for example, with a mixture of hydrochloric acid (HCl) and water ($H_2O$).

As described above, the laminated body 300D, shown in Fig. 5A, is obtained by removing the GaAs substrate 20 and the GaInP etching stop layer 30 from the laminated body 300C (See Fig. 4B) by selective etching, respectively.

Next, while forming an electrode 50 (upper electrode, see Fig. 1) on the GaAs contact layer 40, an electrode 10 (lower electrode) is formed on the InP substrate 310.

Then, the contact layer 40 (See Fig. 5A) other than a part located immediately below the electrode 50 (See Fig. 1) is removed by using the electrode 50 (upper electrode) as a mask, and thereby a contact layer 40A, as shown in Fig. 5B, is formed.

The contact layer 40A can be formed, for example, by etching with a mixture of sulfuric acid ($H_2SO_4$), hydrogen peroxide ($H_2O_2$) and water ($H_2O$) as wet etching solution. Since Al(In)P in the Al(In)P layer 184 does not dissolve in the mixture of sulfuric solution, hydrogen peroxide and water, the wet etching process can be stopped at the Al(In)P layer 184 in the GaInP cell 180.

As described above, the compound-semiconductor photovoltaic cell 300 according to the third embodiment is completed. The compound-semiconductor photovoltaic cell 300 shown in Fig. 5B is identical with the compound-semiconductor photovoltaic cell 300 shown in Fig. 3.

The compound-semiconductor photovoltaic cell 300 has a configuration such that solar light enters the compound-semiconductor photovoltaic cell 300 from a side of a cell of a wide band gap (side of the GaInP cell 180). Meanwhile, an antireflection film is preferably provided on a surface of the Al(In)P layer 184, which solar light enters. The antireflection film is omitted in Fig. 5B.

The n-type Al(In)P ($Al_xIn_{1-x}P$) layer 184 has a lattice constant smaller than the lattice constant of the GaAs substrate 110. The lattice constant of $Al_xIn_{1-x}P$, which is an indirect transition semiconductor, becomes smaller as the Al composition x is increased. Moreover, both band gaps of the $\Gamma$ band and the X band increase. But, a change of the $\Gamma$ band, an absorption coefficient of which is greater, is greater, and an absorption of light with shorter wavelength decreases.

As described above, according to the third embodiment, absorption of light at the Al(In)P ($Al_xIn_{1-x}P$) layer 184, which is a window layer, can be reduced, light of high energy can be transmitted, and thereby a highly-efficient triple-junction compound-semiconductor photovoltaic cell 300 and a manufacturing method of the compound-semiconductor photovoltaic cell 300 can be provided.

Regarding a triple-junction photovoltaic cell 300, such as the compound-semiconductor photovoltaic cell 300 according to the third embodiment, for example, Oyo Butsuri Vol. 79, No. 5, 2010, P. 436 describes, as band gaps of three cells, a combination of 1.9 eV/1.42 eV/1.0 eV and a combination of 1.7 eV/1.2 eV/0.67 eV, which are more preferable than the triple-junction cell of (1.88 eV/1.4 eV/0.67 eV) according to the related art.

However, it is quite difficult to realize the above-described combinations of band gaps by using a lattice constant.

In this respect, according to the third embodiment, since a compound-semiconductor photovoltaic cell 300 is manufactured by joining two cells of lattice constants (laminated body 300A and laminated body 300B (See Fig. 4A)) using a direct junction method, the compound-semiconductor photovoltaic cell 300 including cells having lattice constants which are different from each other can be easily realized.

Meanwhile, in the above description, the embodiment, in which respective cells or the like are formed on an InP substrate 310 and a GaAs substrate 20 by MOCVD method, is explained. However, the respective cells or the like may be formed by MBE (Molecular Beam Epitaxy) method.

Moreover, in the above description, the embodiment, in which the compound-semiconductor photovoltaic cell 300 is manufactured by using laminated bodies 300B and 300A, using the InP substrate 310 and the GaAs substrate 20, respectively, is explained. However, a combination other than the InP substrate 310 and the GaAs substrate 20 may be used.

For example, the laminated bodies 300B and 300A may be manufactured similarly by a combination of a Ge substrate and an InP substrate, a combination of a gallium antimonide (GaSb) substrate and a GaAs substrate, a combination of GaSb substrate and a Ge substrate, a combination of a Si substrate and a Ge substrate, a combination of a Si substrate and a GaAs substrate or the like.

Moreover, in the above description, the embodiment, in which the laminated bodies 300A and 300B are joined directly, is explained. However, they may be joined mechanically.

Moreover, in the above description, the embodiment, in which as an InP lattice matching system material cell a GaInPAs cell 120 is used, is explained. However, the InP lattice matching system material cell is not limited to the GaInPAs cell 120, but a cell expressed by "GaIn(P)As" may be used.

The notation (P) in the expression GaIn(P)As represents both a composition including P and a composition not including P. That is, GaIn(P)As is an expression including both GaInPAs and GaInAs. Therefore, a GaInAs cell may be used instead of the GaInPAs cell 120.

Moreover, in the above description, the embodiment, in which as a GaAs lattice matching system material cell a GaInP cell 180 is used, is explained. However, the GaAs lattice matching system material cell is not limited to the GaInP cell 180, but a cell expressed by "(Al)GaInP(As)" may be used.

The expression "(Al)GaInP(As)" includes both a composition including Al and a composition not including Al. Moreover, the expression "(Al)GaInP(As)" includes both a composition including As and a composition not including As. For this reason, it is expressed by "(Al)" and "(As)". That is, "(Al)GaInP(As)" is an expression including AlGaInPAs, AlGaInP, GaInPAs and GaInP. Therefore, an AlGaInP cell, a GaInPAs cell or an AlGaInPAs cell may be used instead of the GaInP cell 180.

<Fourth embodiment>

In the third embodiment, a triple-junction compound-semiconductor photovoltaic cell 300 configured by a GaInP cell 180, a GaAs cell 160 and a GaInPAs cell 120 is manufactured. A combination of band gaps of three photoelectric conversion cells is 1.9 eV/1.42 eV/1.0 eV.

In a fourth embodiment, by adding a GaInAs cell (0.75 eV) to the GaInP cell 180, the GaAs cell 160 and the GaInPAs cell 120 a four-junction compound-semiconductor photovoltaic cell is provided. A combination of band gaps of the four photoelectric conversion cells are 1.9 eV/1.42 eV/1.0 eV/0.75 eV.

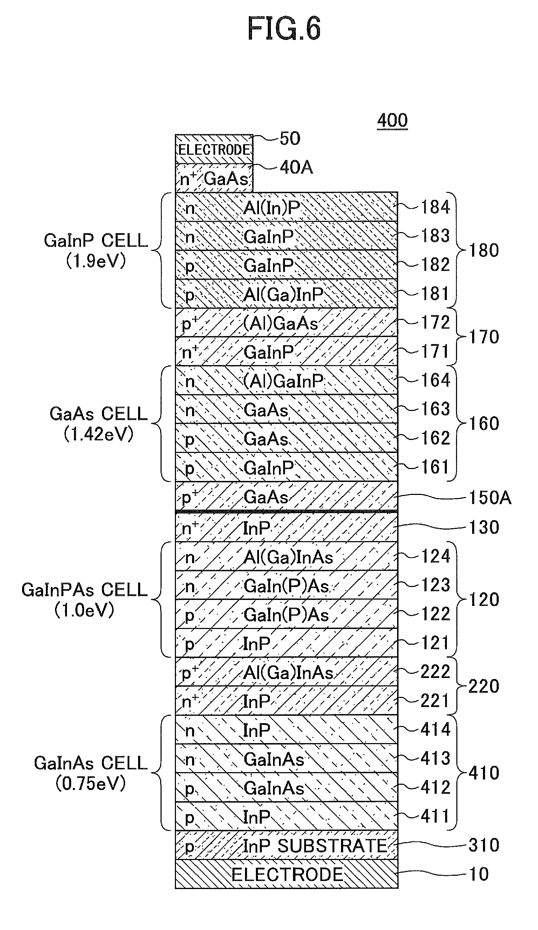

Fig. 6 is a cross-sectional diagram illustrating a compound-semiconductor photovoltaic cell 400 according to the fourth embodiment. In the following, to the same composition element as in the compound-semiconductor photovoltaic cell 300 according to the third embodiment, the same reference numeral is assigned, and an explanation thereof will be omitted.

The compound-semiconductor photovoltaic cell 400 includes an electrode 10, an InP substrate 310, a GaInAs cell 410, a tunnel junction layer 220, a GaInPAs cell 120, a junction layer 130, a tunnel junction layer 150A, a GaAs cell 160, a tunnel junction layer 170, a GaInP cell 180, a contact layer 40A and an electrode 50. Meanwhile, the GaInAs cell 410 is an InP-based photoelectric conversion cell.

Here, the GaInP cell 180 is an example of a first photoelectric conversion cell. The GaAs cell 160 is an example of a second photoelectric conversion cell. The GaInAs cell 410 and the GaInPAs cell 120 are examples of plural third photoelectric conversion cells. The InP substrate 310 is an example of a second compound-semiconductor substrate.

The compound-semiconductor photovoltaic cell 400 according to the fourth embodiment is a four-junction photovoltaic cell in which the GaInAs cell 410 (0.75 eV), the GaInPAs cell 120 (1.0 eV), the GaAs cell 160 (1.42 eV) and the GaInP cell 180 (1.9 eV) are connected in series.

In Fig. 6, an incident direction of light is a direction from an upper part to a lower part in the drawing (direction from the GaInP cell 180 to the GaInAs cell 410).

Proceedings of the 28th IEEE Photovoltaic Specialists Conference (2009) pp. 1090-1093 describes that a band gap balance of a combination of about 1.9 eV/1.4 eV/1.0 eV/0.7 eV is preferable in a four-junction photovoltaic cell.

The compound-semiconductor photovoltaic cell 400 has a configuration obtained by inserting the GaInAs cell 410 and the tunnel junction layer 220 between the substrate 310 and the GaInPAs cell 120 in the compound-semiconductor photovoltaic cell 300 according to the third embodiment.

The GaInAs cell 410 includes a p-type InP layer 411, a p-type GaInAs layer 412, an n-type GaInAs layer 413 and an n-type InP layer 414. The InP layer 411 is a BSF layer, and the InP layer 414 is a window layer.

Here, the GaInAs cell 410 may be regarded as a cell, which is configured with the p-type GaInAs layer 412 and the n-type GaInAs layer 413, without including the InP layer 411 and the InP layer 414. In this case, it may be treated assuming that the InP layer 414 (window layer) is formed on the light incident side of the GaInAs cell 410 which is configured with the p-type GaInAs layer 412 and the n-type GaInAs layer 413, and assuming that the InP layer 411 (BSF layer) is formed on the deep side in the light incident direction.

A band gap between the p-type GaInAs layer 412 and n-type GaInAs layer-413 is 0.75 eV.

The expression "GaInAs" of the GaInAs layer 412 represents specifically $Ga_xIn_{1-x}As$ (0<x1). However, in the following the simplified expression "GaInAs" will be used. The above-described expression is also used for the GaInAs layer 413. A value x of the GaInAs layer 412 may be different from that of the GaInAs layer 413.

The tunnel junction layer 220 is formed between the GaInPAs cell 120 and the GaInAs cell 410. The tunnel junction layer 220 includes an $n^+$-type InP layer 221 and a $p^+$-type Al(Ga)InAs layer 222.

For impurity in the InP layer 221, for example, silicon (Si) may be used so that the conductivity type becomes $n^+$-type. For impurity in the Al(Ga)InAs layer 222, for example, carbon (C) may be used so that the conductivity type becomes $p^+$-type. The $n^+$-type InP layer 221 and the $p^+$-type Al(Ga)InAs layer 222 configure a thin p-n junction which is doped at high concentration.

Both the InP layer 221 of the tunnel junction layer 220 and the Al(Ga)InAs layer 222 are doped at higher concentration than the GaInPAs cell 120. The tunnel junction layer 220 is a junction layer arranged so that an electric current flows between the p-type GaIn(P)As layer 122 of the GaInPAs cell 120 and the n-type GaInAs layer 413 of the GaInAs cell 410 by tunnel junction.

The expression "Al(Ga)InAs" of the Al(Ga)InAs layer 222 represents specifically $Al_xGa_yIn_{1-x-y}As$ (0<x<1, 0≤y<1). However, in the following the simplified expression "Al(Ga)InAs" will be used. Furthermore, the notation "(Ga)" covers the case of including Ga and the case of not including Ga.

The compound-semiconductor photovoltaic cell 400 according to the fourth embodiment has a combination of band gaps of 1.9 eV/1.42 eV/1.0 eV/0.75 eV according to four photoelectric conversion cells of the GaInP cell 180, the GaAs cell 160, the GaInPAs cell 120 and the GaInAs cell 410.

The n-type Al(In)P ($Al_xIn_{1-x}P$) layer 184 has a lattice constant smaller than the lattice constant of the GaAs substrate 110. The lattice constant of $Al_xIn_{1-x}P$, which is an indirect transition semiconductor, becomes smaller as the Al composition x is increased. Moreover, both band gaps of the Γ band and the X band increase. But, a change of the Γ band, an absorption coefficient of which is greater, is greater, and an absorption of light with shorter wavelength decreases.

As described above, according to the fourth embodiment, absorption of light at the Al(In)P ($Al_xIn_{1-x}P$) layer 184, which is a window layer, can be reduced, light of high energy can be transmitted, and thereby a highly-efficient four-junction compound-semiconductor photovoltaic cell 400 and a manufacturing method of the compound-semiconductor photovoltaic cell 400 can be provided.

<Variation of fourth embodiment>

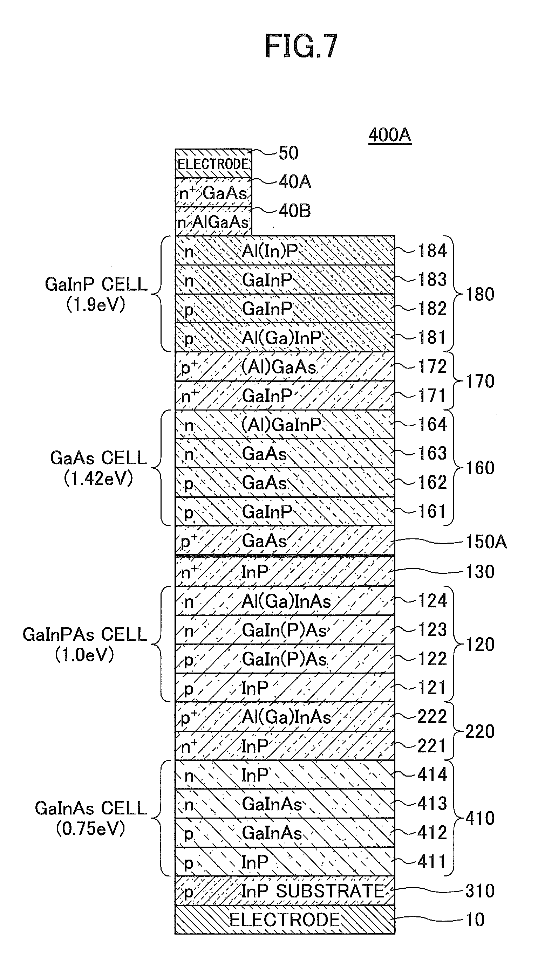

In the following, a first variation of the fourth embodiment will be explained with reference to Fig. 7.

Fig. 7 is a diagram illustrating a compound-semiconductor photovoltaic cell 400A according to the first variation of the fourth embodiment.

The compound-semiconductor photovoltaic cell 400A is obtained by inserting an intermediate layer 40B between the Al(In)P ($Al_xIn_{1-x}P$) layer 184 and the contact layer 40A of the compound-semiconductor photovoltaic cell 400 shown in Fig. 6.

The intermediate layer 40B is an n-type AlGaAs layer and has a band gap between the Al(In)P ($Al_xIn_{1-x}P$) layer 184 and the contact layer 40A ($n^+$-GaAs).

For example, in a case where a difference between band gaps of the Al(In)P ($Al_xIn_{1-x}P$) layer 184 and the contact layer 40A ($n^+$-GaAs) is great, by inserting the intermediate layer 40B having such an intermediate band gap, a resistance value between the Al(In)P ($Al_xIn_{1-x}P$) layer 184 and the contact layer 40A ($n^+$-GaAs) can be reduced and thereby loss can be suppressed.

Especially, for a concentration type cell, reduction of a series resistance of a multi-junction cell is important in order to reduce the energy loss.

According to the first variation of the fourth embodiment, continuity of a band structure between the contact layer 40A and the window layer (Al(In)P ($Al_xIn_{1-x}P$) layer 184) can be improved, and thereby a resistance value can be reduced and a highly-efficient compound-semiconductor photovoltaic cell 400A can be manufactured.

Meanwhile, the contact layer 40A may include indium (In). Then, the contact layer 40A can be expressed by Ga(In)As. A notation "(In)" represents both a composition including In and a composition not including In.

Moreover, as the intermediate layer 40B, (Al)GaInP or AlInP may be used. This is because these materials also have a band gap between the Ga(In)As contact layer 40A and the window layer (Al(In)P ($Al_xIn_{1-x}P$) layer 184).

However, since (Al)GaInP and AlInP cannot be removed by etching, as the Ga(In)As contact layer 40A, a layer absorbing light remains, and it is unfavorable.

In this respect, in the case of using AlGa(In)As for the intermediate layer 40B, it is favorable, since it is the same As-based material and upon performing an etching removal in order to leave only an electrode contact portion of the Ga(In)As contact layer, it can be etched together. Meanwhile, the expression "AlGa(In)As" represents specifically $(Al_xGa_{1-x})_yIn_{1-y}As$ (0<x<1, 0<y≤1). However, in the following the simplified expression "AlGa(In)As" will be used. Furthermore, the notation "(In)" in the expression "AlGa(In)As" represents both a composition including In and a composition not including In.

As described above, according to the first variation of the fourth embodiment, by providing an intermediate layer 40B, absorption of light at the Al(In)P

($Al_xIn_{1-x}P$) layer 184, which is a window layer, can be reduced, light of high energy can be transmitted, and thereby a highly-efficient four-junction type compound-semiconductor photovoltaic cell 400A and a manufacturing method of the compound-semiconductor photovoltaic cell 400A can be provided.

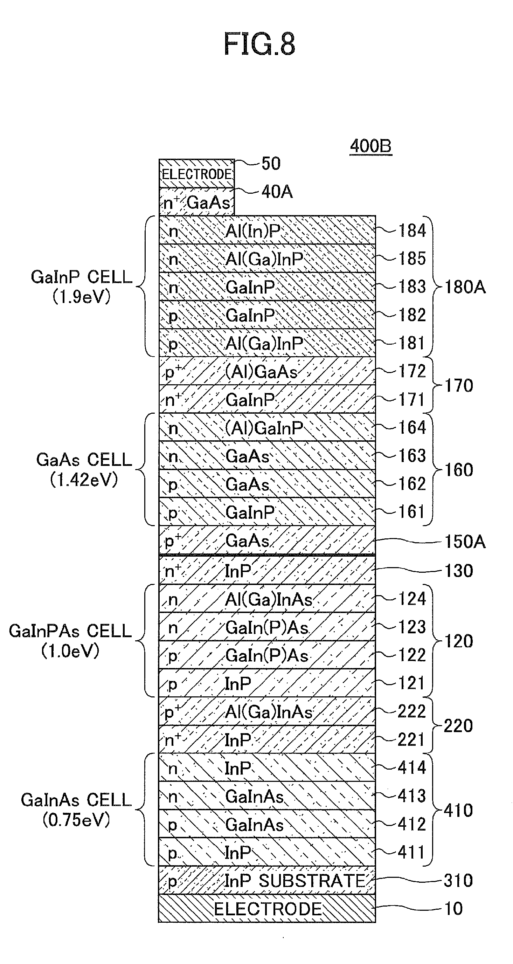

Moreover, a second variation of the fourth embodiment will be explained with reference to Fig. 8.

Fig. 8 is a diagram illustrating a compound-semiconductor photovoltaic cell 400B according to the second variation of the fourth embodiment.

The compound-semiconductor photovoltaic cell 400B is obtained by inserting an intermediate layer 185 between the Al(In)P ($Al_xIn_{1-x}P$) layer 184 and the GaInP layer 183 of the compound-semiconductor photovoltaic cell 400 shown in Fig. 6.

The p-type Al(Ga)InP layer 181, the p-type GaInP layer 182, the n-type GaInP layer 183, the intermediate layer 185 and the n-type Al(In)P layer 184 form a GaInP cell 180A.

The intermediate layer 185 lattice matches with the GaAs substrate and has a band gap between the Al(In)P ($Al_xIn_{1-x}P$) layer 184 and the n-type GaInP absorption layer 183. The intermediate layer 185 is a layer expressed by $(Al_xGa_{1-x})_yIn_{1-y}P$ ($0 \leq x \leq 1$, $0 < y < 1$) and having a composition that gives a band gap between the Al(In)P ($Al_xIn_{1-x}P$) layer 184 and the n-type GaInP absorption layer 183.

In the same way as the band gap difference between the contact layer 40A and the window layer 184 in the first variation of the fourth embodiment, which increases, the band gap difference between the window layer 184 and the n-type GaInP absorption layer 183 increases and a band discontinuity becomes greater, thereby the resistance may become higher.

In this manner, in the case where the band gap difference between the Al(In)P ($Al_xIn_{1-x}P$) layer 184 and the n-type GaInP absorption layer 183 is great, upon inserting the intermediate layer 185 having the above-described intermediate band gap, the resistance value between the Al(In)P ($Al_xIn_{1-x}P$) layer 184 and the n-type GaInP absorption layer 183 can be reduced, thereby loss can be suppressed. Especially, for a concentrating type cell, a reduction of a series resistance of multi-junction cells is important in order to reduce the above-described energy loss.

Therefore, according to the second variation of the fourth embodiment, the continuity of the band structure between the window layer (Al(In)P ($Al_xIn_{1-x}P$) layer 184) and the n-type GaInP absorption layer 183 can be improved, thereby the resistance value can be reduced and a highly-efficient compound-semiconductor photovoltaic cell 400B can be manufactured.

Moreover, a lattice constant of the intermediate layer 185 may be set to an intermediate value between the Al(In)P ($Al_xIn_{1-x}P$) layer 184 having a tensile strain and the n-type GaInP absorption layer 183 which lattice matches with GaAs. In this case, in addition to the above-described effect, the intermediate layer 185 becomes a buffer layer for buffering a difference of the lattice constants, and thereby a high-quality window layer (Al(In)P ($Al_xIn_{1-x}P$) layer 184) having no lattice relaxation but having a tensile strain can be easily obtained.

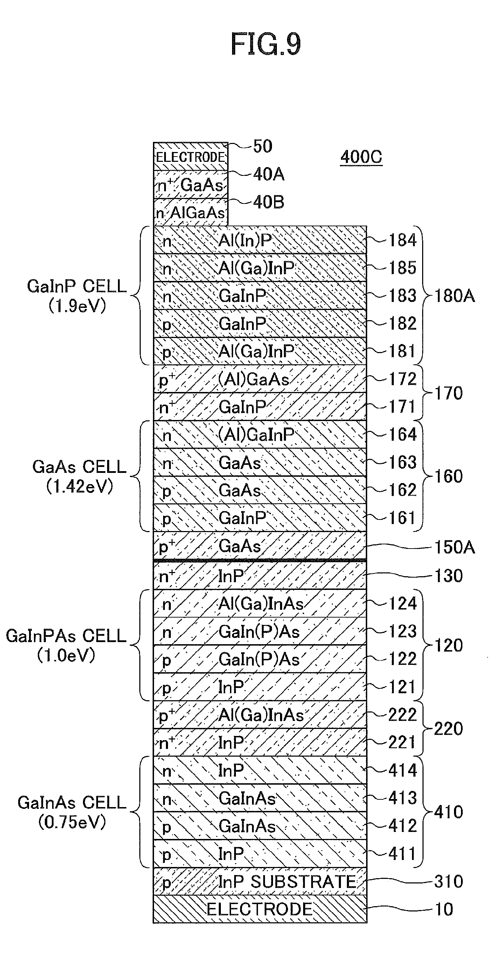

Moreover, a third variation of the fourth embodiment will be explained with reference to Fig. 9.

Fig. 9 is a diagram illustrating a compound-semiconductor photovoltaic cell 400C according to the third variation of the fourth embodiment.

The compound-semiconductor photovoltaic cell 400C is obtained by inserting an intermediate layer 40B between the Al(In)P ($Al_xIn_{1-x}P$) layer 184 and the contact layer 40A of the compound-semiconductor photovoltaic cell 400 shown in Fig. 6, and inserting the intermediate layer 185 shown in Fig. 8 between the Al(In)P ($Al_xIn_{1-x}P$) layer 184 and the GaInP layer 183.

By inserting both the intermediate layer 40B (AlGa(In)As layer) inserted in the first variation of the fourth embodiment and the intermediate layer 185 inserted in the second variation of the fourth embodiment, both effects of the first and second variations of the fourth embodiment can be obtained.

Meanwhile, the intermediate layer 40B and/or the intermediate layer 185 can be inserted in any one of the compound-semiconductor photovoltaic cells 100 to 300 according to the first to third embodiments in the same way as in the compound-semiconductor photovoltaic cell 400 according to the fourth embodiment.

Meanwhile, in the fourth embodiment although a four junction type compound photovoltaic cell is explained, a cell having a band gap greater than 1.9 eV may be provided on a light incident side rather than the GaInP cell 180. In this case, for a window layer of the cell having a band gap greater than 1.9 eV, the same window layer as the window layer (Al(In)P ($Al_xIn_{1-x}P$) layer 184) may be used. In this case, a band gap of the window layer may be optimized in relation to the window layer of the cell having a band gap greater than 1.9 eV.

As described above, a compound-semiconductor photovoltaic cell according to an exemplary embodiment of the present invention and a manufacturing method of the compound-semiconductor photovoltaic cell is explained. Further, the present invention is not limited to these embodiments, but various variations and modifications may be made without departing from the scope of the present invention.

The present application is based on and claims the benefit of priority of Japanese Priority Applications No. 2014-143423 filed on July 11, 2014, and No. 2015-122271 filed on June 17, 2015, the entire contents of which are hereby incorporated by reference.

**Claims**

1. A compound-semiconductor photovoltaic cell including a first photoelectric conversion cell, comprising:

an absorption layer made of a first compound-semiconductor material which lattice matches with gallium arsenide (GaAs) or germanium (Ge); and

a window layer made of aluminum indium phosphide ($Al_{x1}In_{1-x1}P$ ($0<x1\leq1$)), arranged on an incident side of the absorption layer in a light incident direction, having a lattice constant less than a lattice constant of the absorption layer, and having a band gap greater than a band gap of the absorption layer.

2. The compound-semiconductor photovoltaic cell as claimed in claim 1, wherein a content of aluminum (Al) in the window layer is greater than a content of indium (In) in the window layer ($0.5<x1\leq1$).

3. The compound-semiconductor photovoltaic cell as claimed in claim 1 or 2, further comprising a contact layer made of gallium indium arsenide ($Ga_{1-x2}In_{x2}As$ ($0\leq x2<1$)) and arranged on a part of a light incident side of the window layer.

4. The compound-semiconductor photovoltaic cell as claimed in claim 3, further comprising a first intermediate layer made of aluminum gallium indium arsenide ($(Al_{x3}Ga_{1-x3})_{y3}In_{1-y3}As$ ($0<x3<1$, $0<y3\leq1$)), arranged between the window layer and the contact layer, and having a band gap less than or equal to the band gap of the window layer but greater than or equal to a band gap of the contact layer.

5. The compound-semiconductor photovoltaic cell as claimed in any one of claims 1 to 4, wherein the absorption layer is made of aluminum gallium indium phosphide ($(Al_{x4}Ga_{1-x4})_{y4}In_{1-y4}P$ ($0\leq x4<1$, $0<y4<1$)).

6. The compound-semiconductor photovoltaic cell as claimed in claim 5, further comprising a second intermediate layer made of aluminum gallium indium phosphide ($(Al_{x5}Ga_{1-x5})_{y5}In_{1-y5}P$ ($0\leq x5\leq1$, $0\leq y5\leq1$)), arranged between the window layer and the absorption layer, and having a band gap less than or equal to the band gap of the window layer but greater than or equal to the band gap of the absorption layer.

7. The compound-semiconductor photovoltaic cell as claimed in claim 6, wherein the second intermediate layer is made of a material which lattice matches with GaAs or Ge.

8. The compound-semiconductor photovoltaic cell as claimed in claim 6, wherein the second intermediate layer is made of a material having a lattice constant which is between the lattice constant of the window layer and a lattice constant of GaAs or Ge.

9. The compound-semiconductor photovoltaic cell as claimed in any one of claims 1 to 8, further comprising one or more second photoelectric conversion cells arranged on a deep side more than the first photoelectric conversion cell in the light incident direction, and made of a second compound-semiconductor material, which is GaAs-based.

10. The compound-semiconductor photovoltaic cell as claimed in claim 9, further comprising:

a first junction layer formed on a deep side of the one or more second photoelectric conversion cells in the light incident direction; a compound-semiconductor substrate; one or more third photoelectric conversion cells made of a third compound-semiconductor material and laminated on the compound-semiconductor substrate; and a second junction layer laminated on the one or more third photoelectric conversion cells, wherein a surface of the first junction layer opposite to a surface connected to the second photoelectric conversion cells and a surface of the second junction layer opposite to a surface connected to the third photoelectric conversion cells are joined.

11. A manufacturing method of a compound-semiconductor photovoltaic cell including a photoelectric conversion cell, the method comprising:

forming an absorption layer made of a compound-semiconductor material which lattice matches with gallium arsenide (GaAs) or germanium (Ge); and forming a window layer made of aluminum indium phosphide ($Al_{x1}In_{1-x1}P$ ($0<x1\leq1$)) on a light incident side of the absorption layer in a light incident direction, wherein the window layer has a lattice constant less than a lattice constant of the absorption layer and has a band gap greater than a band gap of the absorption layer.

12. A manufacturing method of a compound-semiconductor photovoltaic cell comprising:

forming a first photoelectric conversion cell by laminating a window layer made of aluminum indium phosphide ($Al_{x1}In_{1-x1}P$ ($0<x1\leq1$)) on a first substrate formed of a compound-semiconductor, and laminating an absorption layer made of a first compound-semiconductor material which lattice matches with gallium arsenide (GaAs) or germanium (Ge) on the window layer, wherein the window layer has a lattice constant less than a lattice constant of the absorption layer and has a band gap greater than a band gap of the absorption layer;

laminating one or more second photoelectric conversion cells made of a second compound-semiconductor material, which is GaAs-based, on the first photoelectric conversion cell;

laminating a first junction layer on the second photoelectric conversion cells;

laminating one or more third photoelectric conversion cells made of a third compound-semiconductor material on a second substrate formed of a compound-semiconductor;

laminating a second junction layer on the one or more third photoelectric conversion cells;

joining a surface of the first junction layer opposite to a surface connected to the second photoelectric conversion cells and a surface of the second junction layer opposite to a surface connected to the third photoelectric conversion cells; and

removing the first substrate.

# FIG.1

<u>100</u>

| | | |
|---|---|---|
| | ELECTRODE | ~50 |
| | n⁺ GaAs | ~40A |

GaInP CELL
(1.9eV)

| | | |
|---|---|---|
| n | Al(In)P | ~184 |
| n | GaInP | ~183 |
| p | GaInP | ~182 |
| p | Al(Ga)InP | ~181 |

180

| | | |
|---|---|---|
| p⁺ | (Al)GaAs | ~172 |
| n⁺ | GaInP | ~171 |

170

GaAs CELL
(1.42eV)

| | | |
|---|---|---|
| n | (Al)GaInP | ~164 |
| n | GaAs | ~163 |
| p | GaAs | ~162 |
| p | GaInP | ~161 |

160

| | | |
|---|---|---|
| p | GaAs BUFFER | ~111 |
| p | GaAs SUBSTRATE | ~110 |
| | ELECTRODE | ~10 |

# FIG.2

**200**

ELECTRODE — 50

n⁺ GaAs — 40A

GaInP CELL (1.88eV):
- n Al(In)P — 184
- n GaInP — 183
- p GaInP — 182
- p Al(Ga)InP — 181

} 280

- p⁺ (Al)GaAs — 172
- n⁺ GaInP — 171

} 170

GaInAs CELL (1.4eV):
- n (Al)GaInP — 164
- n Ga(In)As — 263
- p Ga(In)As — 262
- p GaInP — 161

} 260

- p⁺ GaAs — 152
- n⁺ GaAs — 151

} 150

- n GaAs BUFFER — 214
- n GaInP BUFFER — 213

Ge CELL (0.67eV):
- n Ge — 212
- p Ge SUBSTRATE — 211

} 210

ELECTRODE — 10

# FIG.3

<u>300</u>

| | | |
|---|---|---|
| ELECTRODE | ~50 | |
| n⁺ GaAs | ~40A | |

GaInP CELL (1.9eV)
| | | |
|---|---|---|
| n | Al(In)P | ~184 |
| n | GaInP | ~183 |
| p | GaInP | ~182 |
| p | Al(Ga)InP | ~181 |

} 180

| | | |
|---|---|---|
| p⁺ | (Al)GaAs | ~172 |
| n⁺ | GaInP | ~171 |

} 170

GaAs CELL (1.42eV)
| | | |
|---|---|---|
| n | (Al)GaInP | ~164 |
| n | GaAs | ~163 |
| p | GaAs | ~162 |
| p | GaInP | ~161 |

} 160

| | | |
|---|---|---|
| p⁺ | GaAs | ~150A |
| n⁺ | InP | ~130 |

GaInPAs CELL (1.0eV)
| | | |
|---|---|---|
| n | Al(Ga)InAs | ~124 |
| n | GaIn(P)As | ~123 |
| p | GaIn(P)As | ~122 |
| p | InP | ~121 |

} 120

| | | |
|---|---|---|
| p | InP SUBSTRATE | ~310 |
| | ELECTRODE | ~10 |

FIG.4A

FIG.4B

# FIG.5A

300D

GaInP CELL
(1.9eV)

GaAs CELL
(1.42eV)

GaInPAs CELL
(1.0eV)

| | | |
|---|---|---|
| n+ | GaAs | 40 |
| n | Al(In)P | 184 |
| n | GaInP | 183 |
| p | GaInP | 182 |
| p | Al(Ga)InP | 181 |
| p+ | (Al)GaAs | 172 |
| n+ | GaInP | 171 |
| n | (Al)GaInP | 164 |
| n | GaAs | 163 |
| p | GaAs | 162 |
| p | GaInP | 161 |
| p+ | GaAs | 150A |
| n+ | InP | 130 |
| n | Al(Ga)InAs | 124 |
| n | GaIn(P)As | 123 |
| p | GaIn(P)As | 122 |
| p | InP | 121 |
| p | InP SUBSTRATE | 310 |

# FIG.5B

300

ELECTRODE — 50
40A
n+ GaAs

GaInP CELL
(1.9eV)

GaAs CELL
(1.42eV)

GaInPAs CELL
(1.0eV)

| | | |
|---|---|---|
| n | Al(In)P | 184 |
| n | GaInP | 183 |
| p | GaInP | 182 |
| p | Al(Ga)InP | 181 |
| p+ | (Al)GaAs | 172 |
| n+ | GaInP | 171 |
| n | (Al)GaInP | 164 |
| n | GaAs | 163 |
| p | GaAs | 162 |
| p | GaInP | 161 |
| p+ | GaAs | 150A |
| n+ | InP | 130 |
| n | Al(Ga)InAs | 124 |
| n | GaIn(P)As | 123 |
| p | GaIn(P)As | 122 |
| p | InP | 121 |
| p | InP SUBSTRATE | 310 |
| ELECTRODE | | 10 |

EP 2 966 692 A1

# FIG.6

400

# FIG.7

400A

| | |
|---|---|
| ELECTRODE | ~50 |
| n⁺ GaAs | ~40A |
| n AlGaAs | ~40B |

GaInP CELL (1.9eV)
| | | |
|---|---|---|
| n | Al(In)P | ~184 |
| n | GaInP | ~183 |
| p | GaInP | ~182 |
| p | Al(Ga)InP | ~181 |

} ~180

| | | |
|---|---|---|
| p⁺ | (Al)GaAs | ~172 |
| n⁺ | GaInP | ~171 |

} ~170

GaAs CELL (1.42eV)
| | | |
|---|---|---|
| n | (Al)GaInP | ~164 |
| n | GaAs | ~163 |
| p | GaAs | ~162 |
| p | GaInP | ~161 |

} ~160

| | | |
|---|---|---|
| p⁺ | GaAs | ~150A |
| n⁺ | InP | ~130 |

GaInPAs CELL (1.0eV)
| | | |
|---|---|---|
| n | Al(Ga)InAs | ~124 |
| n | GaIn(P)As | ~123 |
| p | GaIn(P)As | ~122 |
| p | InP | ~121 |

} ~120

| | | |
|---|---|---|
| p⁺ | Al(Ga)InAs | ~222 |
| n⁺ | InP | ~221 |

} ~220

GaInAs CELL (0.75eV)
| | | |
|---|---|---|
| n | InP | ~414 |
| n | GaInAs | ~413 |
| p | GaInAs | ~412 |
| p | InP | ~411 |

} ~410

| | | |
|---|---|---|
| p | InP SUBSTRATE | ~310 |
| | ELECTRODE | ~10 |

22

# FIG.8

# FIG.9

400C

| GaInP CELL (1.9eV) | ELECTRODE | | ~50 |
| | n⁺ GaAs | | ~40A |
| | n AlGaAs | | ~40B |

| | n | Al(In)P | ~184 | |
| GaInP CELL (1.9eV) | n | Al(Ga)InP | ~185 | |
| | n | GaInP | ~183 | 180A |
| | p | GaInP | ~182 | |
| | p | Al(Ga)InP | ~181 | |

| | p⁺ | (Al)GaAs | ~172 | 170 |
| | n⁺ | GaInP | ~171 | |

| GaAs CELL (1.42eV) | n | (Al)GaInP | ~164 | |
| | n | GaAs | ~163 | 160 |
| | p | GaAs | ~162 | |
| | p | GaInP | ~161 | |

| | p⁺ | GaAs | | —150A |
| | n⁺ | InP | | —130 |

| GaInPAs CELL (1.0eV) | n | Al(Ga)InAs | ~124 | |
| | n | GaIn(P)As | ~123 | 120 |
| | p | GaIn(P)As | ~122 | |
| | p | InP | ~121 | |

| | p⁺ | Al(Ga)InAs | ~222 | 220 |
| | n⁺ | InP | ~221 | |

| GaInAs CELL (0.75eV) | n | InP | ~414 | |
| | n | GaInAs | ~413 | 410 |
| | p | GaInAs | ~412 | |
| | p | InP | ~411 | |

| | p | InP SUBSTRATE | | —310 |
| | | ELECTRODE | | —10 |

24

**Europäisches Patentamt**
**European Patent Office**
**Office européen des brevets**

# EUROPEAN SEARCH REPORT

Application Number

EP 15 17 6132

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/285526 A1 (JONES-ALBERTUS REBECCA ELIZABETH [US] ET AL) 15 November 2012 (2012-11-15) | 1-11 | INV. H01L31/0216 H01L31/0687 H01L31/18 |
| Y | * abstract; figures 3A,3B,3C,4 * * paragraphs [0007], [0011], [0017] - [0020], [0027] - [0032] * | 12 | |
| X | US 2009/288703 A1 (STAN MARK A [US] ET AL) 26 November 2009 (2009-11-26) * abstract; figures 2,3 * * paragraphs [0058], [0059], [0061] * | 1-7,9,10 | |
| X | US 2003/070707 A1 (KING RICHARD ROLAND [US] ET AL) 17 April 2003 (2003-04-17) | 1-7,9-11 | |
| Y | * abstract; figures 1-6 * * paragraphs [0004] - [0012], [0017], [0023], [0043] - [0045] * | 12 | |
| X | US 2012/216858 A1 (JONES-ALBERTUS REBECCA ELIZABETH [US] ET AL) 30 August 2012 (2012-08-30) | 1-7,9-11 | TECHNICAL FIELDS SEARCHED (IPC) |
| Y | * abstract; figures 1,2A,2B * * paragraphs [0007], [0012], [0015], [0016], [0031], [0032] * | 12 | H01L |
| Y | FRANK DIMROTH ET AL: "Wafer bonded four-junction GaInP/GaAs//GaInAsP/GaInAs concentrator solar cells with 44.7% efficiency", PROGRESS IN PHOTOVOLTAICS: RESEARCH AND APPLICATIONS, vol. 22, no. 3, 13 March 2014 (2014-03-13), pages 277-282, XP055108861, ISSN: 1062-7995, DOI: 10.1002/pip.2475 | 12 | |
| A | * abstract; figures 1,2 * * section 2. EXPERIMENTAL; page 278, left-hand column - page 279, right-hand column * | 1-11 | |

The present search report has been drawn up for all claims

| Place of search | Date of completion of the search | Examiner |
|---|---|---|
| Berlin | 4 December 2015 | Sagol, Bülent Erol |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 15 17 6132

This annex lists the patent family members relating to the patent documents cited in the above-mentioned European search report.
The members are as contained in the European Patent Office EDP file on
The European Patent Office is in no way liable for these particulars which are merely given for the purpose of information.

04-12-2015

| Patent document cited in search report | | | Publication date | Patent family member(s) | | | Publication date |
|---|---|---|---|---|---|---|---|
| US 2012285526 | A1 | | 15-11-2012 | TW | 201251042 | A | 16-12-2012 |
| | | | | US | 2012285526 | A1 | 15-11-2012 |
| | | | | WO | 2012154455 | A1 | 15-11-2012 |
| US 2009288703 | A1 | | 26-11-2009 | NONE | | | |
| US 2003070707 | A1 | | 17-04-2003 | NONE | | | |
| US 2012216858 | A1 | | 30-08-2012 | TW | 201236179 | A | 01-09-2012 |
| | | | | US | 2012216858 | A1 | 30-08-2012 |
| | | | | WO | 2012115838 | A2 | 30-08-2012 |

EPO FORM P0459

For more details about this annex : see Official Journal of the European Patent Office, No. 12/82

## REFERENCES CITED IN THE DESCRIPTION

**Patent documents cited in the description**

- JP 2007115916 A
- JP T2012516578 W
- JP 2014143423 A
- JP 2015122271 A

**Non-patent literature cited in the description**

- *Oyo Butsuri,* 2010, vol. 79 (5), 436
- *Proceedings of the 28th IEEE Photovoltaic Specialists Conference,* 2009, 1090-1093